(19) Europäisches Patentamt
European Patent Office
Office européen des brevets

(11) **EP 4 700 475 A1**

(12) **EUROPEAN PATENT APPLICATION**

(43) Date of publication:
**25.02.2026 Bulletin 2026/09**

(21) Application number: **24196179.6**

(22) Date of filing: **23.08.2024**

(51) International Patent Classification (IPC):
**G03F 7/00** (2006.01)  **G02F 1/35** (2006.01)
**H05G 2/00** (2006.01)

(52) Cooperative Patent Classification (CPC):
**G03F 7/706847; H05G 2/001; H05G 2/0023**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ASML Netherlands B.V.
5500 AH Veldhoven (NL)**

(72) Inventors:
• **ROSCAM ABBING, Sylvianne, Dorothea,
Christina
5500 AH Veldhoven (NL)**

• **SMORENBURG, Petrus, Wilhelmus
5500 AH Veldhoven (NL)**
• **O'DWYER, David
5500 AH Veldhoven (NL)**
• **ROSS, Aimee Jaye
5500 AH Veldhoven (NL)**

(74) Representative: **ASML Netherlands B.V.
Corporate Intellectual Property
P.O. Box 324
5500 AH Veldhoven (NL)**

(54) **METHOD AND APPARATUS FOR SHORT WAVELENGTH METROLOGY**

(57)    Disclosed is a method of and apparatus for metrology or inspection of a structure on a substrate. The method comprises providing first radiation to a first region of a generation medium to generate measurement radiation; providing, simultaneously with the provision of first radiation at the first region, either second radiation to at least a first subregion of the first region so as to suppress generation of the measurement radiation within the first subregion or second radiation to at least a second subregion of the first region to enhance generation of the measurement radiation within the second subregion; illuminating the structure with the measurement radiation; and capturing scattered radiation, having scattered from the structure as a result of the illuminating step.

Fig. 8

**Description**

FIELD

The present invention relates to methods of metrology and in particular for short wavelength metrology and various configurations of a short wavelength illumination source for use with the method.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low $k_1$.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray (SXR) and/or EUV radiation) may be using a pump radiation (e.g., infrared IR radiation) to excite a generating medium, thereby generating an emitted radiation, optionally a high harmonic generation comprising high frequency radiation.

To measure increasingly smaller metrology targets while minimizing crosstalk from neighboring structure, it is desirable to reduce the size of the measurement spot (measurement beam diameter at the target) of an SXR metrology tool.

SUMMARY

According to a first aspect of the invention, there is provided a method of metrology or inspection of a structure on a substrate, comprising: providing first radiation to a first region of a generation medium to generate measurement radiation; providing, simultaneously with the provision of first radiation at the first region, either second radiation to at least a first subregion of the first region so as to suppress generation of the measurement radiation within the first subregion or second radiation to at least a second subregion of the first region to enhance generation of the measurement radiation within the second subregion; illuminating the structure with the measurement radiation; and capturing scattered radiation, having scattered from the structure as a result of the illuminating step.

According to a second aspect of the invention, there is provided a metrology and/or inspection apparatus, comprising: a source arrangement configured to simultaneously provide first radiation to a first region of a generation medium to generate measurement radiation and second radiation to either at least a first subregion of the first region so as to suppress generation of the measurement radiation within the first subregion or to at least a second subregion of the first region to enhance generation of the measurement radiation within the second subregion; an illumination system for illuminating a substrate with the measurement radiation; and at least one detector for detecting scattered radiation, having scattered from the substrate as a result of the illuminating.

BRIEF DESCRIPTION OF THE DRAWINGS

Embodiments will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8 depicts two strategies disclosed herein for reducing measurement beam size of an SXR metrology tool;
- Figure 9 depicts an arrangement for reducing measurement beam size of an SXR metrology tool according to a first example;
- Figure 10 is a plot of intensity against beam size for a first (main) beam, a second (control) beam and the combination of the first beam and second beam, as generated using the arrangement of Figure 8;
- Figure 11 depicts an arrangement for reducing measurement beam size of an SXR metrology tool according to a second example; and
- Figure 12 depicts an arrangement for reducing measurement beam size of an SXR metrology tool according to a third example.

DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

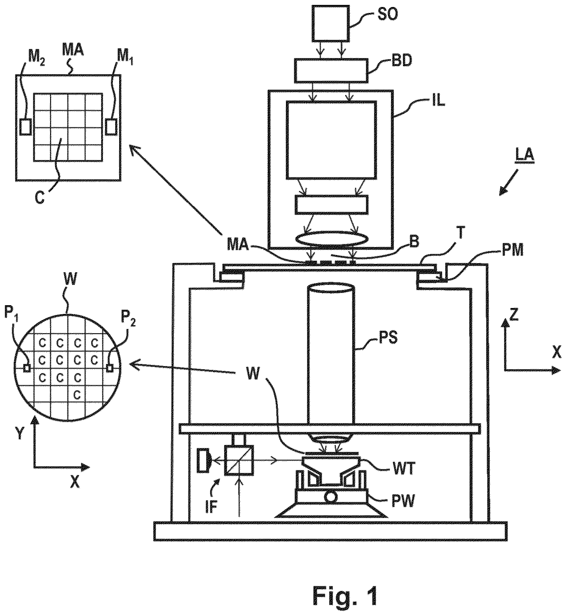

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

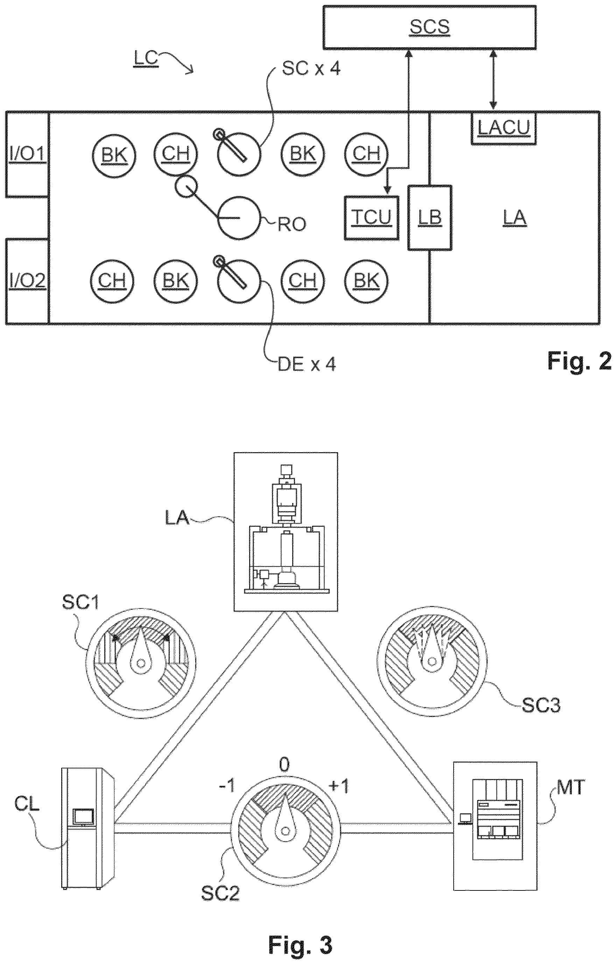

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic patterning apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/-substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

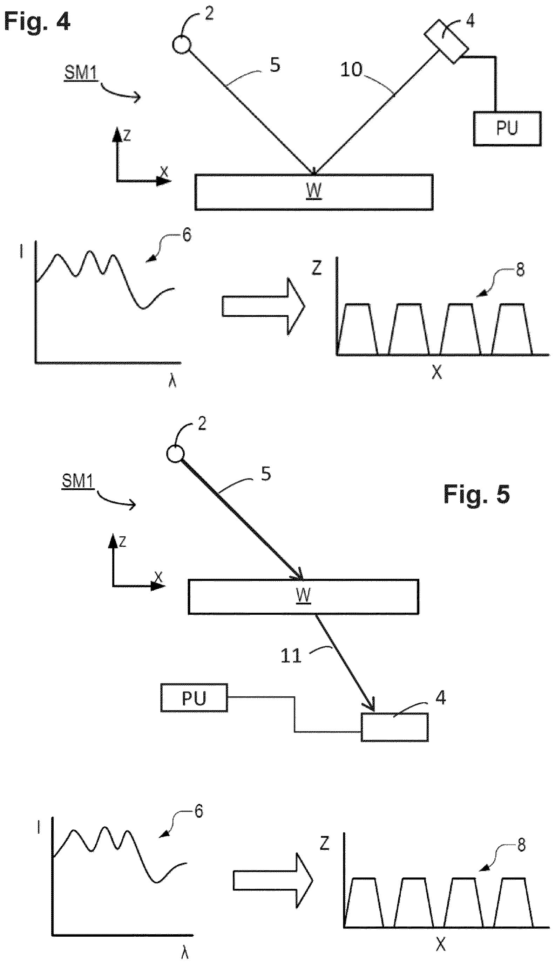

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

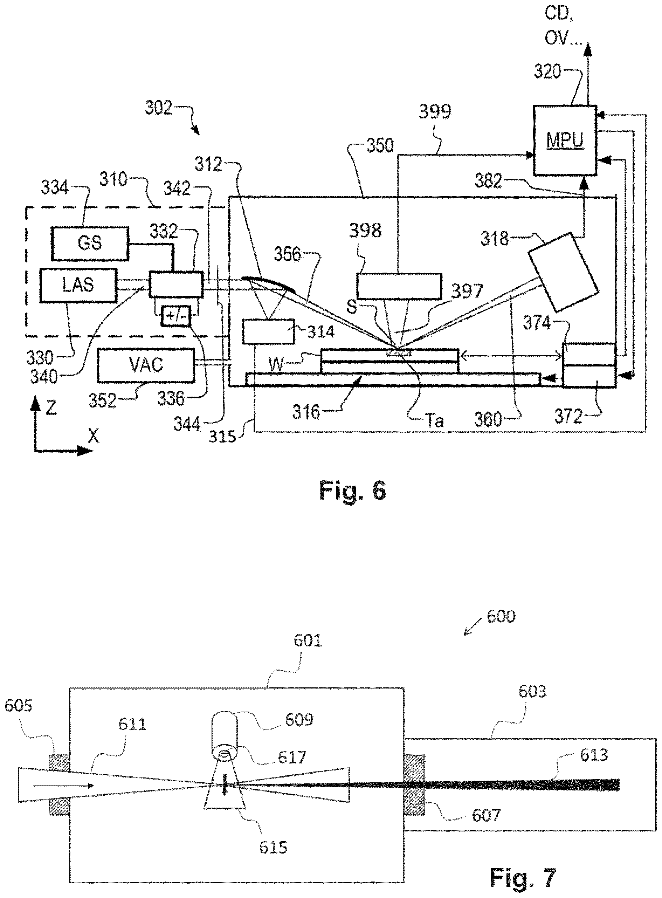

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source, as well as other types of sources, may have a gas target and be a gas jet/nozzle source, a capillary/fiber source or a gas cell source. The HHG source, as well as other types of sources, may have a solid or liquid target. Although HHG source with gas target is described in the text below, it will be appreciated that the invention is not limited to HHG source with gas target and may be used in HHG source with solid or liquid target and other types of source with any target. The gas target, solid target and liquid target may be referred as generating/target medium.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10$\mu$m, for example in the region of 1 $\mu$m (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen ($N_2$), Oxygen ($O_2$), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 $\mu$m in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation, a source may use High Harmonic Generation (HHG) or any other types of sources mentioned above to obtain radiation at the desired wavelength(s). SXR radiation may be defined herein as radiation comprising wavelengths in any of the ranges 0.1 nm to 50 nm, 1nm to 50nm, 5nm to 30nm, 8nm to 20nm or 10nm to 20nm, for example.

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen ($N_2$), Oxygen ($O_2$), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUV SXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUV, SXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+ 1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which a gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

It is desirable that a measurement spot (measurement beam diameter) of an SXR metrology tool, such as has been described, is small. For example, the SXR metrology tool may employ a diffraction-based technique, such that only diffracted SXR radiation from a metrology target is used for inferring a parameter of interest. To minimize crosstalk from the target's surroundings, it may be preferred to have a spot size smaller than the metrology target (i.e., underfilled metrology). However, increasingly smaller metrology targets may also be preferred, e.g., to minimize wafer area usage per target. Present targets may be, for example, in the region of $40\mu m$ square. However, it is proposed that they may become smaller in future, e.g., to less than $30\mu m$ square, less than $20\mu m$ square or in the region of $10\mu m$ square. As such, a smaller spot size than presently generated is desirable.

As has been described, the emitted radiation, which can also be called the measurement radiation, (e.g., broadband radiation or SXR radiation) is generated through a non-linear generation process, for example a High-Harmonic Generation (HHG) process. A pulse, optional femtosecond pulse, is focused at a generation medium such as a gas medium, where ionization, acceleration of electrons, and recombination of electrons takes place, resulting in the generation of SXR radiation, e.g., as has been defined above. The properties of the SXR light are dictated both by the properties of the driving femtosecond pulses and the HHG process itself. Subsequently, the SXR light diverges from the gas jet, and is recollected by an illumination optic such as a toroidal mirror (e.g., which may form part of illumination system 312 in Figure 6). The illumination optic focuses the SXR radiation to a small focus onto a measurement target. The resultant diffracted SXR radiation is detected and used for metrology.

The size of the SXR measurement spot at focus is determined by the SXR divergence, SXR source size, and SXR beam quality ($M^2$). These parameters are constrained by the fundamental driver properties, such as the wavelength and the Gaussian beam properties. Moreover, reducing the size of the SXR source by focusing the drive laser to a smaller spot is not straightforward due to restrictions on accessible pressures in the gas target.

More specifically, The focus spot size of the SXR radiation, $d_0$, is determined by the beam quality of the SXR spot (denoted as $M^2$), the SXR wavelength $\lambda_{SXR}$, the focal length of the mirror f, and the beam size D of the SXR at the toroidal mirror (illumination optic), as

$$d_0 = \frac{M^2 4 \lambda_{SXR} f}{\pi D}.$$

given by . In the SXR metrology tool, it is challenging to reduce the focal length of the illumination optic due to geometrical constraints. More importantly, using an SXR illumination optic with stronger demagnification to facilitate a smaller SXR spot, will lead to a larger SXR divergence and hence to spectral smearing of the SXR diffraction orders on the detector. Also, the wavelength range of the SXR radiation is typically set at the 1-50 nm range (or any of the ranges defined herein), limited by the reflectivity of the SXR illumination optic. The remaining parameters to control to enable a smaller SXR focus are the beam diameter D and the SXR beam quality, denoted by the $M^2$ metric.

The SXR beam diameter at the illumination optic is given by the divergence of the SXR radiation and the SXR source size in the interaction regime, which are both determined during the HHG process. More specifically, the fundamental drive laser focus size determines the achievable SXR source size. Typically, the SXR measurement spot is half the size of that of the fundamental focus. The fundamental focus size is constrained by the fundamental wavelength, the numerical aperture NA of the system, and the required peak intensity in the focus to initiate an efficient HHG process.

The divergence of the SXR beam is given by the SXR wavefront in the generation region, which is defined by a contribution originating from the fundamental drive laser and a contribution originating from the HHG process itself. The phase as a function of radius of each harmonic wavelength can be described as

$$\phi_q(r) = q\,\psi_f(r) + \phi_q^{\mathrm{dipole}}(r)$$

, where q represents the harmonic order, $\psi_f$, the fundamental wavefront and $\phi_q^{\mathrm{dipole}}$, the phase originating from the HHG process itself. The generated SXR radiation consists of many different wavelengths, which are odd harmonics of the fundamental drive laser. As can be seen from the phase relation given above, that the contribution of the fundamental driver scales with the harmonic order and the intrinsic HHG contribution is harmonic dependent. Moreover, both wavefront contributions have a radial dependency, originating from the radial intensity distribution of the drive laser. Effectively, each generated harmonic has a different wavefront, source size and hence divergence, making the total SXR beam a chromatically aberrated beam.

In addition to the polychromatic aspect of the source, each harmonic wavelength is generated by two different electron trajectories, referred to as the long and short trajectories. The contribution of both trajectories to the final SXR signal typically results in a double-Gaussian beam profile in the far-field. In order to optimize the SXR beam quality, it may be preferred to minimize the contribution of the long trajectories.

Reducing the size of the SXR measurement spot size by focusing the drive laser to a smaller spot is not straightforward. This is because increased focusing results in an increase in the phase velocity of the drive laser light (known as the Gouy phase), which has a strong negative effect on the conversion efficiency CE of the source. To optimize the CE of the SXR source, it would be required to counteract the larger Gouy phase using higher gas pressures. This is technically difficult and therefore not preferred.

To reduce the SXR measurement spot size, it is proposed to drive the HHG within a source arrangement by exciting the generation medium with first radiation (e.g., a first beam/pulse) and second radiation (e.g., a second beam/pulse) simultaneously (e.g., with the first radiation and second radiation temporally and spatially overlapped), so as to manipulate the effective SXR source size in the interaction regime.

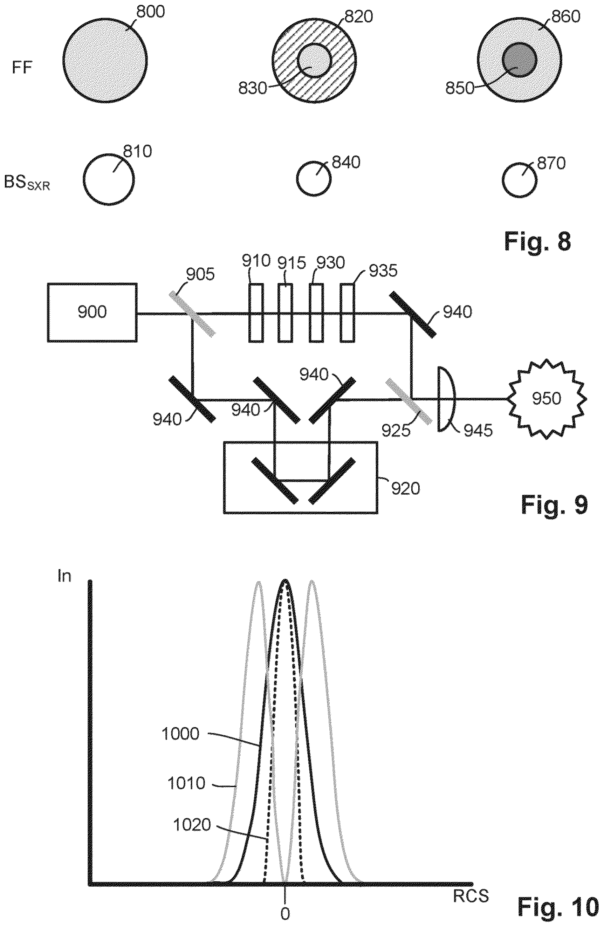

Figure 8 illustrates the difference in fundamental focus and SXR beam size for two different fundamental approaches proposed herein, compared to a fundamental focus 800 and SXR beam size $BS_{SXR}$ 810 of a present arrangement. The first approach comprises implementations which deactivate the SXR generation at an outer region 820 of the interaction region, such that SXR is generated only/mainly within an inner region 830 of the fundamental focus, thereby resulting in a smaller SXR beam size 840 compared to the present arrangement. It should be appreciated that the size of the fundamental focus remains unaltered (which has advantageous properties); rather, the capability to emit SXR is suppressed in the outer region 820. The second approach describes implementations which enhance the SXR at the center 850 of the interaction region with respect to the outer region 860, which also results in a smaller SXR beam size 870 compared to the present arrangement.

It is important to appreciate that the techniques of deactivation of the outer region and enhanced activation of the center region are not equivalent to simply reducing the size of the fundamental focus by stronger focusing down of the drive laser beam. As explained in the previous section, the latter approach would lead to an accelerated phase velocity of the drive laser, and associated need for high gas pressure which is not easily achieved. By contrast, the concepts disclosed herein maintains a favorable phase velocity and high conversion efficiency resulting from a relatively large fundamental focus, but modifies the overall source size using a second beam or control beam.

A first approach comprises deactivation of an outer area of the interaction region using polarization manipulation. Efficient HHG generation requires the acceleration of an electron from the parent atom under the influence of an electric field and, upon switching of the electric field direction, back towards recombination and thus photon emission. Recombination will only occur if the polarization of the electric field is linear. Addition of an orthogonal polarization component (i.e., of the same wavelength as the original beam) will prevent the electron from returning to the parent atom and such that it will not contribute. Controlling the orthogonal polarisation component along (i.e., as a function of) the radius of the focused driving pulse will allow for effective gating of the electron trajectories and thus HHG generation.

More specifically, it is proposed to configure the polarization of an inner region of the focal spot so as to be linearly polarized, and configure the polarization of an outer region of the focal spot so as to not be linearly polarized. Such an approach can suppress HHG emission in the outer region while maintaining HHG emission in the inner region, with the effect of reducing the measurement spot size.

Such an embodiment may provide a means to radially gate the electron trajectory whilst maintaining the central component of the drive pulse (peak intensity, Gouy phase, gas density). An example arrangement for achieving this is to provide a collinear superposition of two drive laser pulses, a first pulse having a TEMoo spatial Gaussian mode (i.e., a common Gaussian beam or fundamental transverse electromagnetic mode), and a second pulse being orthogonally polarised and having a higher order circularly symmetric $TEM_{pi}$ Laguerre Gaussian mode.

Higher order Laguerre Gaussian (LG) modes are characterized by their visual appearance as "donut modes" (e.g., annular modes). A visual characteristic of these modes is zero intensity (and undefined phase) on-axis. These modes are cylindrically symmetric and have a radial index (p) and an azimuthal index (1). The azimuthal index describes the number of $2\pi$ phase rotations around the azimuth (lending the name spiral phase).

LG modes may be generated, for example, using an LG mode generator such as a modulation device or SLM (spatial light modulator), a spiral phase plate or a conical diffractor (e.g., using a suitable element or crystal for generating conical diffraction).

Figure 9 is a schematic drawing showing a basic configuration for implementing such an arrangement. Shown is a drive laser 900 incident on a beam splitter 905 which splits the drive beam into a first beam (first radiation) along a first interferometer arm and a second beam (second radiation) along a second interferometer arm. In the second interferometer arm there is an LG mode generator 910 (e.g., as described) which transforms the Gaussian laser mode into an $LG_{pl}$ mode (p=0, l>0), and a wave plate 915 (e.g., half-wave plate or $\lambda/2$ plate) which rotates the polarization so as to be orthogonal to the radiation in the second interferometer arm. The wave plate 915 may be adjustable, such that rotating the wave plate through 45 degrees enables a tuning of the polarization rotation between a maximum rotation value (leading to an orthogonally polarized beam with respect to the input beam) and minimum rotation value (leading to a parallel polarized with respect to the input beam).

A delay line 920 is provided in the first interferometer arm (the delay line may be provided in either or both interferometer arms), so as to provide temporal overlap of the (e.g., femtosecond) pulses upon recombination after beam combiner 925. While not shown in the other drawings, a delay line may be provided for all (e.g., interferometric) embodiments disclosed herein.

Optionally, there may be provided a spatial beam configurator 930, e.g., lens elements or a variable beam expander. The spatial beam configurator 930 provides for tuning/adjustment of the depletion region in the focal plane, thus providing control over the SXR source size.

Optionally, there may be provided a pulse energy attenuator or intensity attenuating element 935. This may provide an alternative or additional means to control the degree of depletion in the active region.

Also shown are example mirrors or directing elements 940 for directing the beams within each interferometer arm. Following beam recombination, the combined first beam and second beam may be focused by a focusing element 945 onto a HHG medium 950.

The above specific example, the second beam is linearly polarized but orthogonal to the main beam. However, this is only an example, and an alternative example may include the second beam being circularly polarized. Other alternative examples, which are less effective but are within the scope of the concepts disclosed herein, include the second beam having linear polarization at a non-orthogonal and non-parallel angle with respect to the first radiation, or the second beam being elliptically polarized. More generally, the second beam (second radiation) should have a field component orthogonal to the main beam which has an amplitude that is a significant fraction of the amplitude of the first beam (first radiation). Significant in this context may comprise at least a few percent (e.g., at least 3%, at least 5% or at least 10%) of the amplitude of the first beam.

As such, wave plate 915 may comprise one or more wave plates which creates one of these polarizations, as will be known by the skilled person. For example, wave plate 915 may comprise a half wave plate (as already described), a quarter wave plate or a combination of a half wave plate and a quarter wave plate.

Figure 10 is a plot of intensity In against beam radial cross section RCS. Shown is a plot for the first (e.g., common Gaussian or TEMoo) beam 1000, a plot for the second (e.g., Laguerre Gaussian mode or $LG_{01}$) beam 1010, and the resultant combined beam 1020. It should be noted that the combined beam intensity as such does not have the profile 1020; rather, profile 1020 represents the efficiency with which the combined beam can generate harmonics. The second beam 1010 can be seen to have a substantially annular profile. It can be seen that the combined beam 1020 has a diameter smaller than the first beam 1000 (and second beam 1010).

The diameter of the combined beam 1020 may be varied by adjusting/tuning one or more of the LG mode generator 910, spatial beam configurator 930 and/or intensity attenuating element 935.

It is also possible to use a shorter wavelength for the second beam, for example a second harmonic or third harmonic of the fundamental. The shorter wavelengths can be focused to a smaller spot, such that the beam diameter will be even more narrow. It can be appreciated that simply using the second or third harmonic as the sole driver to generate HHG would be less optimal because the overall efficiency of converting laser power into SXR power will be lower than using the fundamental, due to the additional step required for generating the second/third harmonic, and the non-linearity of the CE dependence on drive beam intensity. Also, the spectral cutoff wavelength will shift to longer wavelengths due to the beam having lower intensity

A further example may use a second harmonic (SH) control beam (second beam) to modify electron trajectory trajectories, so as to deactivate an outer region of the SXR generation. It has been demonstrated (e.g., Brugnera, Leonardo, et al. "Trajectory selection in high harmonic generation by controlling the phase between orthogonal two-color fields." Physical review letters 107.15 (2011): 153902, incorporated herein by reference) that the combination of a fundamental laser pulse and its perpendicular SH pulse can suppress either the long or the short trajectories depending on the relative phase.

It is possible to optimize one or more parameters of the generation medium (e.g., gas) such that mainly short electron trajectories generate the SXR radiation. Optimizing the gas may comprise, for example, optimizing one or more of: focusing geometry (e.g., focus distance), gas pressure, gas-jet width and position. A strategy for minimizing the SXR measurement spot size may comprise maximizing or allowing recombination of the short trajectories only in an inner region of the interaction region, while suppressing/deactivating generation of short trajectories outside of this inner region.

As a result of suppressing the short trajectories in the outer region, long trajectories will likely be generated. Hence this embodiment does not provide a strong deactivation of the outer region compared to the other embodiments. Because of this, a radially changing two-color phase wavefront may be imposed on the second beam, e.g., using a modulation device such as an SLM for example.

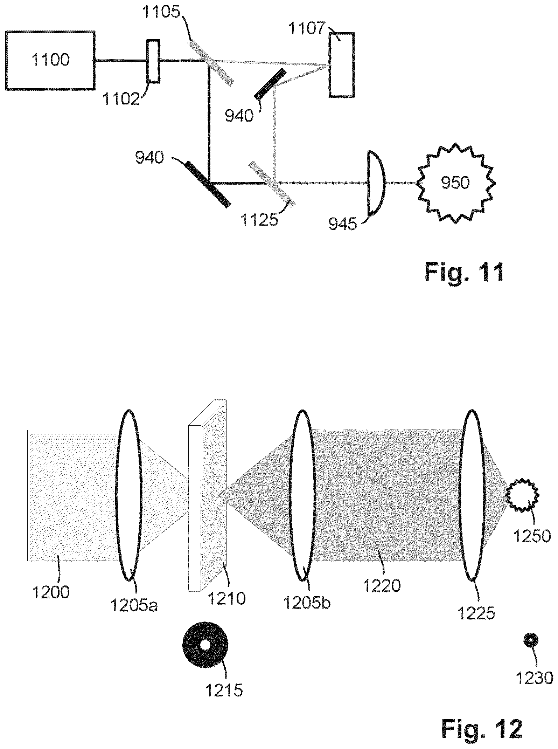

Figure 11 is a schematic drawing illustrating an example interferometric arrangement for implementing such an embodiment. The drive laser 1100 radiation is incident on a second harmonic generator (or more generally a non-fundamental harmonic generator) 1102, which generates second (or other non-fundamental) harmonic radiation (gray) (second radiation) in addition to the fundamental radiation (black) (first radiation). The second harmonic generator 1102 may comprise a non-linear crystal for example. A dichroic mirror 1105 divides the first (fundamental) radiation and second (SH) radiation into respective interferometer arms. The SH radiation may have a radially dependent phase wavefront imposed thereon using an SLM 1107. As an alternative to an SLM, a fixed reflective phase plate or a combination of a fixed transmissive phase plate and a flat mirror may be used. A further dichroic mirror 1125 may be used to recombine the first and second radiation, such that the combined beam is focused by lens 945 at the HHG site 950.

The phase at which the short or long trajectories are maximized in recombination, is referred to as the 'optimal' phase, and is different for each harmonic order and for each short and long trajectory. Hence, this embodiment only enables optimization of the short trajectories of a certain range of harmonics at the same time. Nevertheless, the lowest harmonic orders (longest wavelengths) have the largest SXR source size. Therefore, suppressing the short trajectory generation of the lowest harmonic orders will most effectively modify the total SXR measurement spot size.

Another example will be described which addresses an issue with the examples illustrated in combination with Figures 9 and 10. A difficulty with these examples is that the spiral phase (or other LG mode generator) on the annular second (control) beam at focus may impact the efficiency of HHG suppression as a function of azimuthal angle, resulting in an SXR beam with residual azimuthal dependence. This could impact the quality of the SXR radiation at focus. To achieve a ring profile without (or with minimal) orbital angular momentum (OAM), a method is proposed which utilizes the nonlinear optics of the second harmonic generation (SHG) process.

The concept is shown schematically in Figure 12. Drive radiation of a first wavelength (e.g., an infrared beam 1200 is focused (via lens 1205a) onto a non-fundamental harmonic or SH generator such as a SHG crystal 1210. The drive radiation may have been manipulated to have an annular shape 1215 at the SHG crystal 1210 plane. The SHG crystal 1210 generates second harmonic radiation 1220 of a second wavelength (e.g., green for an infrared input). The infrared radiation may then be dumped, e.g., using a dichroic mirror (not shown). The second harmonic radiation beam 1220 is collimated by a lens 1205b and then directed to a final focus lens (FFL) 1225, which focuses the second harmonic radiation to an annular shaped focus profile 1230 at the HHG generation site 1250. The distance between the collimating lens 1205b and the FFL 1225 may be the sum of their focal lengths. The ratio of the sizes of the annular profile 1230 at the FFL focal plane and at the SHG crystal plane 1215 may be defined by the ratio of the focal lengths of the collimating lens 1205b and the FFL 1225.

The portion of the drive radiation used for SH generation may be picked off to a separate beam path using an interferometry setup. By manipulating the shape of the drive laser focus on the SHG crystal 1210, the generated SH light can be made to have an annular shape. The plane of the crystal is then imaged onto the plane of the HHG generation, providing an annular-shaped SH beam (second radiation) that interferes with the main IR drive beam (first radiation) and suppresses the HHG in this ring.

The manipulation of the drive focus into an annular shape at the SHG crystal plane can be achieved in a number of different ways. For example, a field stop may be provided in the drive beam at the plane of the crystal. This could be implemented by drilling a hole in the crystal or by darkening a center (on-axis) region of the crystal. Alternatively, a spiral phase plate or SLM may be used to impart OAM in the drive beam to form an annular focus. The OAM on the SHG could then later be removed with a second phase plate or SLM; it can be appreciated that the intensity imprint from the generation process would not be removed by this second phase plate.

Optionally, one or more waveplates may be included in the arrangement illustrated in Figure 12, e.g., between elements 1205b, 1225. This may provide an alternative polarization of the second harmonic radiation beam 1220, such as has been described.

Instead of using an annular drive beam at the crystal plane to generate the SH, the annular drive beam itself could be re-imaged onto the focus of the FFL for HHG suppression. In this case, the crystal would be replaced by a mirror with comprising a small aperture or hole (e.g., a hole between $10\mu m$ and $200\mu m$, between $50\mu m$ and $150\mu m$ or around $100\mu m$ in diameter). The resolution of the image of the annular beam at the focus of the FFL may be achieved by providing sufficient space or overhead in the NA of the system (e.g., a large limiting aperture).

It can be appreciated that the damage threshold of an SHG crystal (e.g., a BBO crystal) may be of the order of $10^{11}$ W/cm². The ionization intensity of the HHG gas (e.g., neon or other noble gas) is of order 1014 W/cm2. To manipulate the shape of the electric field so as to avoid recombination of electrons and suppress the HHG, only 10% of the energy in the main beam is required in the second beam and hence the intensity in the HHG gas of the ring beam should be of the order $10^{13}$ W/cm². Therefore, the beam size may be demagnified from the SHG crystal plane to the HHG plane by a factor of 10, to provide 100 times higher intensity in the HHG focus than in the SHG crystal. For example, for a $20\mu m$ outer beam radius in the HHG, may be generated using a $200\mu m$ outer beam radius in the crystal.

As has already been mentioned, instead of deactivation of the outer region of the SXR interaction regime, it is also possible to enable smaller SXR measurement spot sizes by enhancing the center of the signal generation. This strategy will still lead to generation of SXR signal in the outer region of the gas target, however the contrast with respect to the center will be larger, such that acquisition times can go down due to a higher signal-to-noise ratio.

As described above, it is not possible to simply scale down the focus size of the fundamental, due to loss in CE. Therefore, it is proposed to use shorter wavelengths (such as the second harmonic SH, third harmonic TH and/or other higher harmonics HH greater than one) as a control beam (second radiation), since shorter wavelengths will be focused down to a smaller focus, while maintaining the same gradient for the Guoy phase as of the fundamental.

For example, parallel polarization may be imposed between the fundamental and the SH/TH/HH radiation, thereby enhancing the SXR generation in the center of the gas jet, and effectively create a smaller SXR measurement spot. This may be implemented within an interferometric setup, where one arm is used to drive the HHG with the fundamental, and the other arm is used to generate the SH/TH/HH control beam.

It is proposed that some of the embodiments may be combined, e.g., to suppress generation in the outer region and enhance generation in the inner region.

The methods described herein may provide an SXR measurement spot having a cross-section (e.g., diameter) no larger than $35\mu m$, no larger than $30\mu m$, no larger than $25\mu m$, no larger than $20\mu m$, no larger than $15\mu m$ or no larger than $10\mu m$. Such a measurement spot may be used to measure a structure such as a metrology target on a substrate.

Further embodiments are disclosed in the subsequent numbered clauses:

1. A method of metrology or inspection of a structure on a substrate, comprising:

providing a first radiation to a first region of a generation medium to generate a measurement radiation;

providing, simultaneously with the provision of first radiation at the first region, either a second radiation to at least a first subregion of the first region so as to suppress generation of the measurement radiation within the first subregion or second radiation to at least a second subregion of the first region to enhance generation of the measurement radiation within the second subregion;

illuminating the structure with the measurement radiation; and

capturing a scattered radiation, having scattered from the structure as a result of the illuminating step.

2. A method as claimed in clause 1, wherein the first subregion comprises an outer subregion or the second subregion comprises an inner subregion with respect to an optical axis of at least the first radiation

3. A method as claimed in clause 1 or 2, wherein the first radiation is linearly polarized.

4. A method as claimed in any preceding clause, wherein the second radiation suppresses generation of the measurement radiation within the first subregion.

5. A method as claimed in clause 4, wherein the first radiation comprises a common Gaussian beam.

6. A method as claimed in any preceding clause, wherein the second radiation is not linearly polarized.

7. A method as claimed in any preceding clause, wherein the second radiation is circularly polarized or elliptically polarized.

8. A method as claimed in clause 4 or 5, wherein the second radiation is linearly polarized with a polarization at a non-zero angle with respect to the first radiation.

9. A method as claimed in clause 8, wherein the first radiation and the second radiation are orthogonally polarized.

10. A method as claimed in clause 8 or 9, comprising tuning the polarization rotation between the first radiation and the second radiation.

11. A method as claimed in any preceding clause, wherein the second radiation comprises a Laguerre Gaussian mode having a radial index of zero and an azimuthal index greater than zero.

12. A method as claimed in any preceding clause, comprising generating the second radiation using a spatial light modulator, a spiral phase plate or a conical diffractor.

13. A method as claimed in any preceding clause, comprising spatially configuring the second radiation and/or attenuating an intensity of the second radiation.

14. A method as claimed in any preceding clause, wherein the second radiation comprises a shorter wavelength than the first radiation.

15. A method as claimed in any of clauses 4 to 14, wherein the second radiation has a substantially annular cross section.

16. A method as claimed in any preceding clause, wherein the second radiation comprises a non-fundamental harmonic of the fundamental defined by the first radiation.

17. A method as claimed in clause 16, wherein the second radiation comprises at least a second harmonic.

18. A method as claimed in clause 16 or 17, comprising generating the non-fundamental harmonic second radiation from the first radiation.

19. A method as claimed in clause 18, comprising providing a field stop at a plane where the non-fundamental harmonic second radiation is generated from the first radiation, so as to impose a substantially annular cross section to the second radiation.

20. A method as claimed in any of clauses 16 to 19, comprising imposing an orbital angular momentum on the second radiation to impose a substantially annular cross section to the second radiation.

21. A method as claimed in clause 16 or 17, wherein the second radiation is configured to modify electron trajectories in the first subregion.

22. A method as claimed in clause 21, wherein the second radiation is configured to suppress generation of short electron trajectories in the first subregion, while not suppressing generation of short electron trajectories in the second subregion.

23. A method as claimed in clause 22, comprising optimizing one or more parameters of the generation medium to suppress the generation of short electron trajectories in the first subregion.

24. A method as claimed in clause 21, 22 or 23, comprising imposing a radially dependent phase wavefront onto the second radiation.

25. A method as claimed in clause 16 or 17, comprising enhancing generation of the measurement radiation within the second subregion.

26. A method as claimed in clause 25, wherein the method comprises focusing the second radiation to a smaller focused diameter than the focused diameter of the first radiation while maintaining the same gradient for the Guoy phase for the first radiation and second radiation.

27. A method as claimed in clause 25 or 26, wherein the first radiation and second radiation comprise parallel polarization.

28. A method as claimed in any preceding clause, comprising configuring a delay between the first radiation and second radiation to provide temporal overlap of the first radiation and second radiation.

29. A method as claimed in any preceding clause, wherein the illuminating step comprises focusing the measurement radiation onto the structure so as to define a measurement spot no larger than $31\mu m$ onto the structure.

30. A method as claimed in any preceding clause, wherein the illuminating step comprises focusing the measurement radiation onto the structure so as to define a measurement spot no larger than $21\mu m$ onto the structure.

31. A method as claimed in any preceding clause, wherein the illuminating step comprises focusing the measurement radiation onto the structure so as to define a measurement spot no larger than $10\mu m$ onto the structure.

32. A method as claimed in any preceding clause, wherein the generation medium comprises a gas medium.

33. A method as claimed in any preceding clause, wherein the structure comprises a structure formed by a semiconductor manufacturing process.

34. A method as claimed in any preceding clause, comprising determining a parameter of interest of the structure from the scattered radiation.

35. A method as claimed in any preceding clause, wherein the measurement radiation is generated in a non-linear generation process.

36. A method as claimed in any preceding clause, wherein the generation medium comprises a high harmonic generation medium and the measurement radiation being generated in a high harmonic generation process, or wherein the generation medium comprises a laser produced plasma medium and the measurement radiation being generated in a laser produced plasma process.

37. A method as claimed in any preceding clause, wherein the measurement radiation comprises broadband radiation having wavelengths in a range of 1 nm to 50 nm.

38. A metrology and/or inspection apparatus configured to perform the method of any preceding clause.

39. A metrology and/or inspection apparatus, comprising:

a source arrangement configured to simultaneously provide first radiation to a first region of a generation medium to generate measurement radiation and second radiation to either at least a first subregion of the first region so as to suppress generation of the measurement radiation within the first subregion or to at least a second subregion of the first region to enhance generation of the measurement radiation within the second subregion ;
an illumination system for illuminating a substrate with the measurement radiation; and
at least one detector for detecting scattered radiation, having scattered from the substrate as a result of the illuminating.

40. A metrology and/or inspection apparatus as claimed in clause 39, configured such that the first subregion comprises an outer subregion or the second subregion comprises an inner subregion with respect to an optical axis of at least the first radiation

41. A metrology and/or inspection apparatus as claimed in clause 39 or 40, configured such that the first radiation is linearly polarized.

42. A metrology and/or inspection apparatus as claimed in any of clauses 39 to 41, configured such that the second radiation suppresses generation of the measurement radiation within the first subregion.

43. A metrology and/or inspection apparatus as claimed in clause 42, configured such that the first radiation comprises a common Gaussian beam.

44. A metrology and/or inspection apparatus as claimed in any of clauses 39 to 43, configured such that the second radiation is not linearly polarized.

45. A metrology and/or inspection apparatus as claimed in clause 44, comprising at least one wave plate configured to impose a circular or elliptical polarization on the second radiation.

46. A metrology and/or inspection apparatus as claimed in clause 42 or 43, comprising at least one wave plate configured to impose a linear polarization on the second radiation at a non-zero angle with respect to the first radiation.

47. A metrology and/or inspection apparatus as claimed in clause 46, wherein the at least one wave plate configured to impose a polarization to the second radiation which is orthogonal to that of the first radiation.

48. A metrology and/or inspection apparatus as claimed in clause 46 or 47, wherein the wave plate is tunable to tune the polarization rotation between the first radiation and the second radiation.

49. A metrology and/or inspection apparatus as claimed in any of clauses 39 to 48, comprising a Laguerre Gaussian mode generator to impose a Laguerre Gaussian mode on the second radiation, having a radial index of zero and an azimuthal index greater than zero.

50. A metrology and/or inspection apparatus as claimed clause 49, wherein the Laguerre Gaussian mode generator comprises a spatial light modulator, a spiral phase plate or a conical diffractor.

51. A metrology and/or inspection apparatus as claimed in any of clauses 39 to 50, comprising a spatial beam configurator configured to spatially configure the second radiation and/or an intensity attenuating element configured for attenuating an intensity of the second radiation.

52. A metrology and/or inspection apparatus as claimed in any of clauses 39 to 51, configured such that the second radiation comprises a shorter wavelength than the first radiation.

53. A metrology and/or inspection apparatus as claimed in any of clauses 42 to 52, configured such that the second radiation has a substantially annular cross section.

54. A metrology and/or inspection apparatus as claimed in any of clauses 39 to 53, comprising a non-fundamental harmonic generator configured to generate one or more non-fundamental harmonics.

55. A metrology and/or inspection apparatus as claimed in clause 54, wherein the non-fundamental harmonic generator comprises at least a second harmonic generator configured to generate a second harmonic.

56. A metrology and/or inspection apparatus as claimed in clause 54 or 55, wherein the non-fundamental harmonic generator comprises a non-linear crystal.

57. A metrology and/or inspection apparatus as claimed in clause any of clauses 54 to 56, comprising a field stop at a plane where the non-fundamental harmonic radiation is generated from the first radiation, so as to impose a substantially annular cross section to the second radiation.

58. A metrology and/or inspection apparatus as claimed in any of clauses 54 to 56, comprising a spiral phase plate operable to impose an orbital angular momentum on the second radiation.

59. A metrology and/or inspection apparatus as claimed in clause 54 or 55, wherein the second radiation is configured to modify electron trajectories in the first subregion.

60. A metrology and/or inspection apparatus as claimed in clause 59, wherein the second radiation is configured to suppress generation of short electron trajectories in the first subregion, while not suppressing generation of short electron trajectories in the second subregion.

61. A metrology and/or inspection apparatus as claimed in clause 60, wherein one or more parameters of the generation medium has been optimized to suppress the generation of short electron trajectories in the first subregion.

62. A metrology and/or inspection apparatus as claimed in clause 59, 60 or 61, comprising a spatial light modulator configured to impose a radially dependent phase wavefront onto the second radiation.

63. A metrology and/or inspection apparatus as claimed in clause 54 or 55, comprising enhancing generation of the measurement radiation within the second subregion.

64. A metrology and/or inspection apparatus as claimed in clause 63, wherein the metrology and/or inspection apparatus wherein the source arrangement is configured to focus the second radiation to a smaller focused diameter than the focused diameter of the first radiation while maintaining the same gradient for the Guoy phase for the first radiation and second radiation.

65. A metrology and/or inspection apparatus as claimed in clause 63 or 64, configured such that the first radiation and second radiation comprise parallel polarization.

66. A metrology and/or inspection apparatus as claimed in any of clauses 39 to 65, comprising a delay line configured to impose a delay between the first radiation and second radiation to provide temporal overlap of the first radiation and second radiation.

67. A metrology and/or inspection apparatus as claimed in any of clauses 39 to 66, wherein the illumination system is configured to illuminate the substrate with a measurement spot no larger than 30μm.

68. A metrology and/or inspection apparatus as claimed in any of clauses 39 to 66, wherein the illumination system is configured to illuminate the substrate with a measurement spot no larger than 20μm.

69. A metrology and/or inspection apparatus as claimed in any of clauses 39 to 66, wherein the illumination system is configured to illuminate the substrate with a measurement spot no larger than 10μm.

70. A metrology and/or inspection apparatus as claimed in any of clauses 39 to 69, wherein the generation medium comprises a gas medium.

71. A metrology and/or inspection apparatus as claimed in any of clauses 39 to 70, wherein the substrate comprises structure formed by a semiconductor manufacturing process.

72. A metrology and/or inspection apparatus as claimed in any of clauses 39 to 71, comprising a processor configured to determine a parameter of interest from the scattered radiation.

73. A metrology and/or inspection apparatus as claimed in any of clauses 39 to 72, wherein the generation medium comprises a non-linear generation medium operable to generate the measurement radiation in a non-linear generation process.

74. A metrology and/or inspection apparatus as claimed in any of clauses 39 to 73, wherein the generation medium comprises a high harmonic generation medium operable to generate the measurement radiation in a high harmonic generation process, or wherein the generation medium comprises a laser produced plasma medium and the measurement radiation being generated in a laser produced plasma process.

75. A metrology and/or inspection apparatus as claimed in any of clauses 39 to 74, wherein the measurement radiation comprises broadband radiation having wavelengths in a range of 10 nm to 20 nm.

76. A metrology and/or inspection apparatus as claimed in any of clauses 39 to 75, wherein the source arrangement comprises an interferometer being operable to divide input radiation into the first radiation and second radiation, and to recombine the first radiation and second radiation so as to simultaneously provide the first radiation and second radiation to the generation medium.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, including radio waves, microwaves, infrared, (visible) light, ultraviolet, X-rays, and gamma rays.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

**Claims**

1. A metrology and/or inspection apparatus, comprising:

   a source arrangement configured to simultaneously provide first radiation to a first region of a generation medium to generate measurement radiation and second radiation to either at least a first subregion of the first region so as to suppress generation of the measurement radiation within the first subregion or to at least a second subregion of the first region to enhance generation of the measurement radiation within the second subregion;
   an illumination system for illuminating a substrate with the measurement radiation; and
   at least one detector for detecting scattered radiation, having scattered from the substrate as a result of the illuminating.

2. A metrology and/or inspection apparatus as claimed in claim 1, configured such that the first subregion comprises an outer subregion or the second subregion comprises an inner subregion with respect to an optical axis of at least the first radiation

3. A metrology and/or inspection apparatus as claimed in claim 1 or 2, configured such that the first radiation is linearly polarized.

4. A metrology and/or inspection apparatus as claimed in any preceding claim, configured such that the second radiation suppresses generation of the measurement radiation within the first subregion.

5. A metrology and/or inspection apparatus as claimed in any preceding claim, configured such that the second radiation is not linearly polarized.

6. A metrology and/or inspection apparatus as claimed in any preceding claim, comprising at least one wave plate configured to impose a linear polarization on the second radiation at a non-zero angle with respect to the first radiation.

7. A metrology and/or inspection apparatus as claimed in any preceding claim, comprising a spatial beam configurator configured to spatially configure the second radiation and/or an intensity attenuating element configured for attenuating an intensity of the second radiation.

8. A metrology and/or inspection apparatus as claimed in any preceding claim, configured such that the second radiation comprises a shorter wavelength than the first radiation.

9. A metrology and/or inspection apparatus as claimed in any of claims 4 to 8, configured such that the second radiation has a substantially annular cross section.

10. A metrology and/or inspection apparatus as claimed in any preceding claim, comprising a non-fundamental harmonic generator configured to generate one or more non-fundamental harmonics.

11. A metrology and/or inspection apparatus as claimed in claim 10, comprising a field stop at a plane where the one or more non-fundamental harmonics is generated from the first radiation, so as to impose a substantially annular cross section to the second radiation.

12. A metrology and/or inspection apparatus as claimed in claim 10, comprising enhancing generation of the measurement radiation within the second subregion, and optionally the metrology and/or inspection apparatus is configured such that the first radiation and second radiation comprise parallel polarization.

13. A metrology and/or inspection apparatus as claimed in any preceding claim, wherein the generation medium comprises a high harmonic generation medium operable to generate the measurement radiation in a high harmonic generation process, or wherein the generation medium comprises a laser produced plasma medium and the measurement radiation being generated in a laser produced plasma process.

**14.** A metrology and/or inspection apparatus as claimed in any preceding claim, wherein the source arrangement comprises an interferometer being operable to divide input radiation into the first radiation and second radiation, and to recombine the first radiation and second radiation so as to simultaneously provide the first radiation and second radiation to the generation medium.

**15.** A method of metrology or inspection of a structure on a substrate, comprising:

providing a first radiation to a first region of a generation medium to generate a measurement radiation;
providing, simultaneously with the provision of first radiation at the first region, either a second radiation to at least a first subregion of the first region so as to suppress generation of the measurement radiation within the first subregion or second radiation to at least a second subregion of the first region to enhance generation of the measurement radiation within the second subregion;
illuminating the structure with the measurement radiation; and
capturing a scattered radiation, having scattered from the structure as a result of the illuminating step.

**Fig. 1**

**Fig. 2**

**Fig. 3**

**Fig. 4**

SM1

PU

W

I

6

Z

8

X

λ

2

5

10

4

Z

X

**Fig. 5**

SM1

2

5

W

11

PU

4

Z

X

I

6

Z

8

X

λ

**Fig. 6**

**Fig. 7**

FF

800

820
830

860
850

BS$_{SXR}$

810

840

870

**Fig. 8**

900

905

910 915 930 935

940

940 940 940

925

945

950

920

**Fig. 9**

In

1000

1010

1020

0

RCS

**Fig. 10**

**Fig. 11**

**Fig. 12**

Europäisches
Patentamt
European
Patent Office
Office européen
des brevets

# EUROPEAN SEARCH REPORT

**Application Number**

EP 24 19 6179

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2020/067258 A1 (SMORENBURG PETRUS WILHELMUS [NL] ET AL) 27 February 2020 (2020-02-27) * abstract * * figures 1-5 * * paragraphs [0001], [0008], [0009], [0079] - [0081] * | 1-15 | INV. G03F7/00 G02F1/35 H05G2/00 |
| A | US 2022/390388 A1 (SMORENBURG PETRUS WILHELMUS [NL]) 8 December 2022 (2022-12-08) * abstract * * figures 1-7 * * paragraphs [0002], [0076] - [0088] * | 1-15 | |
| A | EP 4 321 933 A1 (ASML NETHERLANDS BV [NL]) 14 February 2024 (2024-02-14) * abstract * * figures 1-8 * * paragraphs [0001], [0064] - [0085] * | 1-15 | |
| A | KR 2007 0059404 A (KOREA RES INST OF STANDARDS [KR]) 12 June 2007 (2007-06-12) * the whole document * | 1-15 | **TECHNICAL FIELDS SEARCHED (IPC)** G03F H05G G02F |

The present search report has been drawn up for all claims

| Place of search | Date of completion of the search | Examiner |
|---|---|---|
| Munich | 6 May 2025 | Andersen, Ole |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 6179

This annex lists the patent family members relating to the patent documents cited in the above-mentioned European search report.
The members are as contained in the European Patent Office EDP file on
The European Patent Office is in no way liable for these particulars which are merely given for the purpose of information.

06-05-2025

| Patent document cited in search report | Publication date | Patent family member(s) | | Publication date |
|---|---|---|---|---|
| US 2020067258 A1 | 27-02-2020 | CN | 112586089 A | 30-03-2021 |
| | | EP | 3614813 A1 | 26-02-2020 |
| | | IL | 280923 A | 29-04-2021 |
| | | KR | 20210025680 A | 09-03-2021 |
| | | NL | 2021854 A | 07-11-2018 |
| | | TW | 202014805 A | 16-04-2020 |
| | | TW | 202046027 A | 16-12-2020 |
| | | US | 2020067258 A1 | 27-02-2020 |
| | | WO | 2020038648 A1 | 27-02-2020 |
| US 2022390388 A1 | 08-12-2022 | CN | 114631055 A | 14-06-2022 |
| | | EP | 3816721 A1 | 05-05-2021 |
| | | EP | 4052092 A1 | 07-09-2022 |
| | | IL | 292444 A | 01-06-2022 |
| | | US | 2022390388 A1 | 08-12-2022 |
| | | WO | 2021083673 A1 | 06-05-2021 |
| EP 4321933 A1 | 14-02-2024 | CN | 119452308 A | 14-02-2025 |
| | | EP | 4321933 A1 | 14-02-2024 |
| | | WO | 2024033025 A1 | 15-02-2024 |
| KR 20070059404 A | 12-06-2007 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006066855 A1
- US 2011102753 A1
- US 20120044470 A
- US 6952253 B
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B

- US 13000229 B
- US 13033135 B
- US 13533110 B
- US 13891410 B
- WO 2011012624 A
- US 20160161863 A
- US 20160370717 A1
- US 2007224518 A
- US 2019003988 A1
- US 2019215940 A1
- US 20130304424 A1
- US 2014019097 A1, Bakeman
- US 20170184981 A1
- US 2016282282 A1

**Non-patent literature cited in the description**

- **LEMAILLET et al.** Intercomparison between optical and X-ray scatterometry measurements of FinFET structures. *Proc. of SPIE*, 2013, vol. 8681

- **BRUGNERA ; LEONARDO et al.** Trajectory selection in high harmonic generation by controlling the phase between orthogonal two-color fields. *Physical review letters*, 2011, vol. 107 (15), 153902